# EUROPÄISCHE PATENTSCHRIFT

(11) **EP 4 214 348 B1**
(45) Veröffentlichungstag und Bekanntmachung des Hinweises auf die Patenterteilung: **03.07.2024**
(21) Anmeldenummer: 21777773.9
(22) Anmeldetag: 16.09.2021
(51) Int. Cl.: C23C 14/06, C23C 14/30, C23C 14/24, H01J 37/305

(54) **VORRICHTUNG UND VERFAHREN ZUM ABSCHEIDEN HARTER KOHLENSTOFFSCHICHTEN**
APPARATUS AND METHOD FOR SEPARATING HARD CARBON LAYERS
DISPOSITIF ET PROCÉDÉ DE DÉPÔT DE COUCHES DE CARBONE DURES

(30) Priorität: 17.09.2020 DE 102020124269
(43) Veröffentlichungstag der Anmeldung: 26.07.2023
(73) Patentinhaber: Fraunhofer-Gesellschaft zur Förderung der angewandten Forschung e.V., 80686 München (DE)
(72) Erfinder: SCHEFFEL, Bert, 01277 Dresden (DE); TENBUSCH, Matthias, 01277 Dresden (DE); SAAGER, Stefan, 01277 Dresden (DE)
(86) Internationale Anmeldenummer: PCT/EP2021/075505
(87) Internationale Veröffentlichungsnummer: WO 2022/058437

(56) Entgegenhaltungen:
- DE-A1-102010 041 150
- JP-A- H04 365 855
- JP-A- S56 163 265
- JP-A- 2001 020 064
- US-A- 4 961 958

## Beschreibung

Die Erfindung betrifft eine Vorrichtung und ein Verfahren zum Beschichten eines Substrates mit einer sehr harten Kohlenstoffschicht, basierend auf einer Bogenverdampfung von Graphit innerhalb einer Vakuumkammer.

Es ist bekannt, dass Kohlenstoffschichten mit vielfältigen Eigenschaften hergestellt werden können, die vor allem auf unterschiedlich ausgeprägte Strukturen zurückzuführen sind. Die Schichthärte von Kohlenstoffschichten variiert von hart und diamantähnlich bis weich und graphitähnlich. In vielen Untersuchungen wurde demonstriert, dass die Schichteigenschaften, insbesondere die Schichthärte, von den Anteilen der sp³- und sp²-Bindungen und vom Wasserstoffgehalt abhängen. Weiterhin ist bekannt, dass die höchsten Härten bei wasserstofffreien Schichten mit einem sehr hohen Anteil an sp³-Bindungen erreicht werden. Superharte Kohlenstoffschichten mit einem Young's Module von 400 GPa bis 800 GPa werden auch als tetraedrisch gebundener amorpher Kohlenstoff (ta-C) bezeichnet. Üblicherweise muss die Temperatur der zu beschichtenden Substrate relativ niedrig (< 300 °C) gehalten werden, damit sich ein hoher Anteil der sp³- Bindungen ausbildet und eine sehr hohe Schichthärte erzielt werden kann.

Es sind verschiedene Verfahren bekannt, mit denen solche superharten, tetraedrisch gebundenen amorphen Kohlenstoffschichten hergestellt werden können. In H. Schulz et al., Applied Physics A, Pulsed arc depostion of super-hard amorphus carbon films, Vol. 78, 2004, S. 675 - 679, sind Verfahren beschrieben, bei denen ein kathodischer Vakuumbogen, stochastisch oder von einem Magnetfeld geführt, auf einer Graphitkathode mit kleinem Fußpunkt ausgebildet wird. Der Kohlenstoff der Graphitkathode sublimiert dabei und wird aufgrund der Eigenschaften der Bogenentladung hochgradig ionisiert. Die ionisierten Kohlenstoffpartikel werden auf einem zu beschichtenden Substrat abgeschieden und bilden aufgrund ihrer relativ hohen Energie (im Bereich von etwa 10-40 eV) eine Kohlenstoffstruktur mit einem sehr hohen Anteil an sp³-Bindungen aus. Aufgrund der sehr hohen Leistungsdichte der Bogenentladung an der Graphit-Kathode entstehen jedoch als Droplets benannte sehr kleine Spritzer, die auch als Makropartikel bezeichnet werden. Diese sind relativ weich, werden in einer aufwachsenden Schicht eingelagert und beeinträchtigen die Schichteigenschaften der aufwachsenden Schicht. Mit magnetischen Filtern, die den von der Kathode ausgehenden Plasmastrom umlenken und die Droplets an zusätzlichen Wänden auffangen, kann der Dropletanteil in den abgeschiedenen Schichten erheblich gesenkt werden. Die Beschichtungsrate wird durch eine solche magnetische Filterung allerdings erheblich geschwächt.

In der zuvor benannten Schrift sind des Weiteren Verfahren beschrieben, bei denen ein pulsförmiger Laserbeschuss zum Zünden einer gepulsten, stromstarken Bogenentladung verwendet wird. Bei derartigen laserinduzierten, gepulsten Entladungen werden Stromstärken von mehreren 100 A bis über 1000 A erreicht. Aufgrund der extrem hohen Leistungsdichte auf der Graphitoberfläche werden jedoch ebenfalls Droplets emittiert und in die Schicht eingebaut. Deshalb können auch bei diesen Verfahren magnetische Filter eingesetzt werden, mit denen der Dropletanteil in den Schichten erheblich gesenkt werden kann. Der technische Aufwand mit den verschiedenen Komponenten, wie Laser, Bogenentladung und Magnetfilter, ist dabei allerdings sehr hoch.

Bei sogenannten Laserablations-Verfahren die zum Beispiel aus Steffen Weissmantel, et al., Surface & Coating Technology, Preparation of superhard amorphous carbon films with low internal stress, Vol. 188/189, 2004, S. 268 - 273, bekannt sind, wird ein Hochleistungslaserpuls im Vakuum auf ein Graphittarget gerichtet, was ein pulsartiges Verdampfen von Kohlenstoff bewirkt, der auf einem Substrat abgeschieden wird. Die Laserablation hat viele Gemeinsamkeiten mit der kathodischen Bogenbeschichtung. In beiden Fällen wird eine sehr hohe Leistungsdichte auf dem Graphittarget erzielt, in Folge dessen ein hoch ionisiertes Plasma erzeugt wird, dabei werden relativ hochenergetische Teilchen im Bereich von etwa 10-40 eV erzeugt und es treten auch bei der Laserablation Droplets auf.

Mittels Magnetronsputtern können härtere Schichten hergestellt werden als durch bloßes Verdampfen von Kohlenstoff, wie es zum Beispiel aus M. Stüber, FZ Karlsruhe, Wissenschaftliche Berichte, Magnetron-gesputterte superharte, amorphe Kohlenstoffschichten mit gradiertem Schichtaufbau, FZKA 5919,1997, bekannt ist. Auch dies ist auf einen höheren sp³-Anteil der Bindungen zurückzuführen und wird verursacht durch einen gewissen Anteil hochenergetischer Partikel im Dampf- bzw. Plasmastrom vom Target zum Substrat. Beim Magnetronsputtern ist die Leistungsdichte am Graphittarget erheblich geringer als bei den Bogenentladungs- und Laserverfahren. Vermutlich ist dies die Ursache dafür, dass mit dem Magnetronsputtern nicht so hohe Härten bei Kohlenstoffschichten erreicht werden können wie mit den beschriebenen Bogenentladungs- und Laserverfahren. Allerdings werden keine oder nur wenige Droplets in den Schichten eingelagert. Weiterer relevanter Stand der Technik wird in dem Patentdokument US 4 961 958 A offenbart.

Die zuvor benannten Verfahren haben den Nachteil, dass meist ein erheblicher Anteil von Droplets in das Schichtgefüge eingebaut bzw. ein erheblicher technischer Aufwand benötigt wird, um die Droplets in Dichte und Größe zu reduzieren. Offenbar besteht ein Zusammenhang zwischen der Anwendung sehr hoher Leistungsdichten am Graphittarget, den damit erzielbaren hohen Teilchenenergien und den sehr hohen erzielbaren Schichthärten.

Der Erfindung liegt daher das technische Problem zugrunde, ein Verfahren und eine Vorrichtung zum Abscheiden von Kohlenstoffschichten zu schaffen, mittels derer die Nachteile aus dem Stand der Technik überwunden werden können. Insbesondere soll es mit dem erfindungsgemäßen Verfahren und der erfindungsgemäßen Vorrichtung möglich sein, Kohlenstoffschichten mit einer sehr hohen Härte abzuscheiden und dabei das Einlagern von Droplets gegenüber dem Stand der Technik zu verringern.

Die Lösung des technischen Problems ergibt sich durch Gegenstände mit den Merkmalen der Patentansprüche 1 und 8.

Weitere vorteilhafte Ausgestaltungen der Erfindung ergeben sich aus den abhängigen Ansprüchen.

Eine erfindungsgemäße Vorrichtung basiert auf Elementen, die von einer anodischen Bogenverdampfung bekannt sind. Eine erste Stromversorgungseinrichtung speist eine Bogenentladung zwischen einer als Kathode fungierenden Elektronenquelle und dem als Anode fungierenden Verdampfungsmaterial. Hierbei wird das Material der Anode maßgeblich durch Beschuss mit Elektronen geheizt und dadurch in die Dampfphase überführt. Eine energetische Anregung des Dampfes vollzieht sich durch Stöße zwischen den zur Anode fließenden Elektronen der Bogenentladung und den Dampfpartikeln. Als Elektronenquelle kann zum Beispiel eine sogenannte heiße Hohlkathode verwendet werden. Unter einer heißen Hohlkathode soll eine Hohlkatode verstanden sein, welche von einem Edelgas, wie zum Beispiel Argon, durchströmt wird und die während des Betriebes auf eine Temperatur von mindestens 1000 °C aufgeheizt wird. Ein Magnetsystem, das aus einer Anordnung von Dauermagneten und aus einer Magnetspule aufgebaut ist, ist ringförmig um das als Anode geschaltete Verdampfungsmaterial angeordnet. Das Magnetfeld dieses Magnetsystems dient zum Führen der Elektronen auf das Anodenmaterial und zum Erhöhen der Elektronendichte in der Anodennähe, was zu einem intensiven Aufheizen des Anodenmaterials und zu einem höheren Ionisieren des von der Anode emittierten Dampfes führt.

Bei einer erfindungsgemäßen Vorrichtung ist das kohlenstoffhaltige Material der Anode in Form eines zylindrischen Graphitstabes ausgebildet. Der Graphitstab kann beispielsweise innerhalb eines Führungsrohrs angeordnet und mittels einer Nachführeinrichtung in Abhängigkeit von der Verdampfungsrate innerhalb des Führungsrohres nachgeschoben werden, so dass sich die Lage der sublimierenden Stirnseite des Graphitstabes während des Prozesses nicht wesentlich verändert.

Erfindungsgemäß ist das als Graphitstab ausgebildete Verdampfungsmaterial zumindest an dem zu verdampfenden Stabende von mindestens einem Wärmedämmelement vollumfänglich umschlossen, welches gewährleistet, dass die durch die Bogenentladung erzeugte Wärme am Graphitstab zum Beispiel nur im geringen Anteil über ein Führungsrohr abgeleitet wird.

Bei einer Ausführungsform umfasst das mindestens eine Wärmedämmelement ein poröses Material mit einem Schmelzpunkt größer 2000 °C, welches die Innenwandung des Führungsrohrs auskleidet. Das poröse Material weist somit die Form eines Hohlzylinders auf, in dessen Inneren der zu verdampfende Graphitstab gelagert bzw. mittels der Nachführeinrichtung nachgeschoben wird.

Besonders geeignet als poröses Material ist zum Beispiel Graphitfilz. Unter Graphitfilz soll im Erfindungssinn ein Gewebe oder ein ungeordnetes Geflecht aus Kohlenstofffasern verstanden sein. Es sind jedoch auch poröse Gefüge aus anderen Materialien, wie beispielsweise gesinterte Aluminiumoxidkeramiken oder Metallschaumwerksoffe aus Molybdän, Tantal oder Wolfram, möglich. Der Graphitfilz erfüllte im Wesentlichen zwei Funktionen. Zum einen gewährleistet der Graphitfilz eine Wärmedämmung zwischen dem Graphitstab und dem Führungsrohr, wodurch an der zu verdampfenden Stirnseite des Graphitstabes die hohen Temperaturen erzeugbar sind, die das Sublimieren von Kohlenstoff ermöglichen. Zum anderen dient der Graphitfilz einer elektrischen Kontaktierung des zu verdampfenden Graphitstabes mit dem elektrischen Spannungspotenzial des Pluspols der ersten Stromversorgungsreinrichtung, welches vom Führungsrohr über den Graphitfilz zum Graphitstab weitergeleitet wird.

Vorzugsweise weist das Führungsrohr am oberen Ende einen Anschlag auf, welcher verhindert, dass das poröse Material, wie zum Beispiel Graphitfilz, beim Nachführen des Graphitstabes oben aus dem Führungsrohr herausgeschoben wird. Das Führungsrohr kann zum Beispiel aus Graphit bestehen. Es sind aber auch Metalle und Metallverbindungen oder auch eine Keramik mit einem Schmelzpunkt von mindestens 1000 °C als Material für das Führungsrohr geeignet.

Bei einer alternativen Ausführungsform ist das als Graphitstab ausgebildete Verdampfungsmaterial zumindest an dem zu verdampfenden Stabende von mindestens zwei, voneinander beabstandeten, rohrförmigen Wärmereflektoren vollumfänglich umschlossen. Die Wärmereflektoren bestehen bevorzugt aus einem Material mit hoher Schmelztemperatur von über 2000 °C. Beispielhaft seien an dieser Stelle aufgezählt, Materialien wie Graphit, Metalle oder Metallverbindungen welche Tantal, Molybdän oder Wolfram enthalten oder Keramiken, wie zum Beispiel Aluminiumoxid oder Bornitrid. Dadurch, dass die mindestens beiden rohrförmigen Wärmereflektoren voneinander beabstandet sind, wird die Wärmeleitung unterbrochen und somit ein Abfluss von Wärmeenergie verringert, wodurch das Verdampfen des Graphitstabes stabil aufrechterhalten werden kann.

Beim erfindungsgemäßen Verfahren zum Abscheiden einer Kohlenstoffschicht wird mittels einer ersten Stromversorgungseinrichtung eine Bogenentladung zwischen einer Elektronenquelle und einem Verdampfungsmaterial ausgebildet, wobei der Minuspol der ersten Stromversorgungseinrichtung elektrisch leitfähig mit der Elektronenquelle und der Pluspol der ersten Stromversorgungseinrichtung elektrisch leitfähig mit dem Verdampfungsmaterial verbunden wird. Dabei werden ein Permanentmagnetsystem und mindestens eine Magnetspule rotationssymmetrisch um das Verdampfungsmaterial angeordnet. Das erfindungsgemäße Verfahren zeichnet sich ferner dadurch aus, dass das Verdampfungsmaterial als Graphitstab ausgebildet und zumindest an dem zu verdampfenden Stabende des Graphitstabes von mindestens einem Wärmedämmelement umschlossen wird.

Eine erfindungsgemäße Vorrichtung und das erfindungsgemäße Verfahren ermöglichen es, Kohlenstoffschichten mittels anodischer Bogenverdampfung innerhalb einer Vakuumkammer auf einem Substrat abzuscheiden und den Abscheideprozess über einen längeren Zeitraum stabil aufrechtzuerhalten. Dabei können Kohlenstoffschichten mit einer sehr hohen Härte abgeschieden werden.

Die vorliegende Erfindung wird nachfolgend anhand von Ausführungsbeispielen näher erläutert. Die Figuren zeigen:
- Fig. 1: eine schematische Darstellung einer erfindungsgemäßen Vorrichtung;
- Fig. 2: eine vergrößerte schematische Darstellung des oberen Endes des Führungsrohrs 1 aus Fig. 1;
- Fig. 3: eine schematische Darstellung einer alternativen erfindungsgemäßen Vorrichtung.

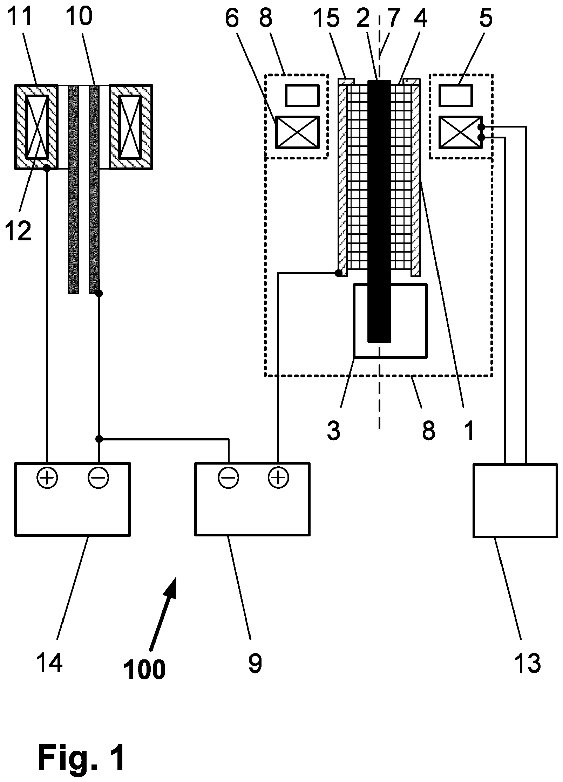

In Fig. 1 ist eine erfindungsgemäße Vorrichtung 100 schematisch dargestellt, mit welcher auch das erfindungsgemäße Verfahren ausgeführt werden kann. Die erfindungsgemäße Vorrichtung 100 umfasst ein innerhalb einer Vakuumkammer (welche in Fig. 1 nicht dargestellt wurde) angeordnetes Führungsrohr 1, in welchem ein Verdampfungsmaterial 2 gelagert ist. Das Verdampfungsmaterial 2 ist als Graphitstab ausgebildet und kann während des Betriebes der Vorrichtung 100 mittels einer Nachführeinrichtung 3 innerhalb des Führungsrohres nachgeschoben werden. Erfindungsgemäß ist die Innenwandung des Führungsrohrs 1 mit Graphitfilz 4 als Wärmedämmelement ausgekleidet, so dass das als Graphitstab ausgebildete Verdampfungsmaterial 2, zumindest am oberen Ende des Graphitstabes, an welchem das Verdampfungsmaterial 2 verdampft wird, vom Graphitfilz 4 umschlossen ist. Das Führungsrohr 1 ist außerdem von einem ringförmigen Permanentmagnetsystem 5 und von einer ringförmigen Magnetspule 6 umschlossen, welche in Summe ein rotationssymmetrisches Gesamtmagnetfeld um die Rohrachse 7 des Führungsrohrs 1 herum erzeugen.

Das Permanentmagnetsystem 5, die Magnetspule 6, der Verdampfertiegel 1 und die Nachführeinrichtung 3 sind zumindest teilweise von einem Gehäuse 8 umschlossen, welches dafür sorgt, dass diese Bauteile während des Betriebes der Vorrichtung 100 nicht mit Verdampfungsmaterial oder elektrisch geladenen Teilchen beaufschlagt werden. Bei einer Ausführungsform ist das Gehäuse 8 wassergekühlt, um die von der Magnetspule 6 erzeugte Wärme abzuführen.

Eine erste Stromversorgungseinrichtung 9 stellt den Strom zum Ausbilden einer Bogenentladung zwischen einer Elektronenquelle 10 und dem Verdampfungsmaterial 2 bereit, wobei der Minuspol der ersten Stromversorgungseinrichtung 9 elektrisch leitfähig mit der Elektronenquelle 10 und der Pluspol der ersten Stromversorgungseinrichtung 9 elektrisch leitfähig mit dem Führungsrohr 1 verbunden ist. Da der Graphitfilz 4 elektrisch leitfähig ist und sowohl einen mechanischen Kontakt mit dem Führungsrohr 1 als auch mit dem Verdampfungsmaterial 1 ausübt, weist auch das Verdampfungsmaterial 2 das gleiche elektrische Spannungspotenzial auf, wie das Führungsrohr 1. Auf diese Weise wird eine Bogenentladung zwischen der als Kathode geschalteten Elektronenquelle 10 und dem als Anode geschalteten Verdampfungsmaterial 2 ausgebildet, wodurch das Verdampfungsmaterial 2 erhitzt und durch Sublimieren verdampft wird.

Die Elektronenquelle 10 ist im Ausführungsbeispiel gemäß Fig. 1 als heiße Hohlkathode ausgebildet. Alternativ sind für eine erfindungsgemäße Vorrichtung auch alle anderen, aus dem Stand der Technik bekannten Elektronenquellen, welche bei einer anodischen Bogenverdampfung eingesetzt werden, geeignet. Eine Anode 11 und eine Magnetspule 12 sind ringförmig um die als Hohlkathode ausgebildete Elektronenquelle 10 angeordnet. Eine Stromversorgungseinrichtung, welche einen Stromfluss durch die Magnetspule 12 bewirkt, wurde in Fig. 1 aus Übersichtsgründen nicht dargestellt.

Dargestellt sind in Fig. 1 des Weiteren eine zweite Stromversorgungseinrichtung 8, welche einen elektrischen Stromfluss durch die Magnetspule 6 bewirkt und eine dritte Stromversorgungseinrichtung 14, deren Minuspol elektrisch leitfähig mit der Elektronenquelle 10 und deren Pluspol mit der Anode 11 verbunden sind, wodurch das Zünden einer Hohlkathoden-Entladung gewährleistet wird. Die Hohlkathode wird außerdem, wie aus dem Stand der Technik bekannt, von einem Arbeitsgas durchströmt und während des Betriebes auf Temperaturen von über 1000 °C geheizt.

Bei einer Ausführungsform ist die zweite Stromversorgungseinrichtung 13 derart ausgebildet, dass mit dieser die Stärke des elektrischen Stroms, welcher durch die Magnetspule 6 fließt, periodisch verändert werden kann. Weil die zweite Stromversorgungseinrichtung 13 bei dieser Ausführungsform einen elektrischen Strom mit gepulster Stromstärke bereitstellen kann, wird eine solche Stromversorgungseinrichtung auch als Puls-Stromversorgungseinrichtung bezeichnet. Es wurde festgestellt, dass eine Änderung der Stärke des die Magnetspule 6 durchfließenden elektrischen Stroms eine Veränderung der Richtungsverteilung der Dampfausbreitung des verdampften Verdampfungsmaterials 2 zur Folge hat. Diese Änderung der Dampfausbreitungs-Charakteristik in Abhängigkeit von der Spulenstromstärke ist reproduzierbar. Je nach Kombination der Magnetfelder des Permanentmagnetsystems 5 und der Magnetspule 6 kann die Dampfausbreitungsrichtung bevorzugt in Richtung der Achse 7 oder in einem Winkel geneigt zu dieser Achsenrichtung emittiert werden. Die Ursache für die Beeinflussung der Ausbreitungscharakteristik durch das Magnetfeld liegt vermutlich darin begründet, dass der sich ausbildende Dampfstrom hochgradig ionisiert ist und die Plasmaströmung im Magnetfeld umgelenkt wird.

Der Effekt, dass die Richtungsverteilung der Dampfausbreitung bei einer erfindungsgemäßen Vorrichtung und mit dem erfindungsgemäßen Verfahren von der Höhe der Spulenstromstärke beeinflusst wird, kann genutzt werden. Durch ein periodisches Verändern der Stärke des die Magnetspule 6 durchfließenden elektrischen Stromes lässt sich demzufolge in einfacher Weise die Schichtdickenverteilung auf einem zu beschichtenden Substrat beeinflussen. Wird die Stärke des Stromflusses durch die Magnetspule und somit auch die Feldstärke des Gesamtmagnetfeldes erhöht, hat dies zur Folge, dass die Dampfausbreitung des verdampften Verdampfungsmaterials 2 mehr in die Richtung der Achse 7 ausgerichtet wird, wohingegen ein Absenken der Stärke des Stromflusses durch die Magnetspule und somit auch der Feldstärke des Gesamtmagnetfeldes bewirkt, dass die Hauptdampfausbreitungsrichtung mit einem Winkel zur Achse 7, der mehr als 60° betragen kann, ausgebildet wird.

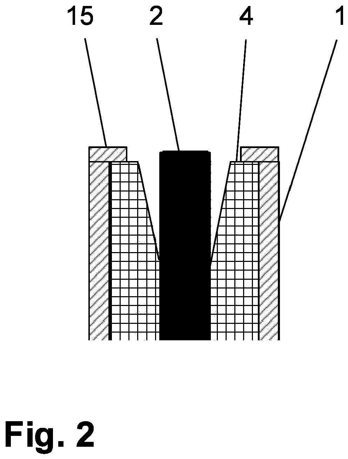

In Fig. 2 ist ein oberer Teil des Führungsrohrs 1 aus Fig. 1 detaillierter dargestellt. Zu erkennen ist hier, dass das Führungsrohr 1 einen oberen Anschlag 15 aufweist, welcher verhindert, dass der Graphitfilz 4 beim Nachführen des als Graphitstab ausgebildeten Verdampfungsmaterials 2 nach oben aus dem Führungsrohr 1 herausgeschoben wird. Ebenfalls ist in Fig. 2 veranschaulicht, dass der Graphitfilz 4 in der Nähe der verdampfenden Stirnseite des Graphitstabes während des Betriebes einer erfindungsgemäßen Vorrichtung teilweise verdampft, so dass sich ein trichterförmiger Spalt zwischen dem nicht verdampften Graphitfilz 4 und dem als Graphitstab ausgebildeten Verdampfungsmaterial 2 ausbildet. Dieser Spalt hat jedoch weder eine Auswirkung auf die Bogenentladung noch eine Auswirkung auf das Verdampfen von Kohlenstoff. Wie zuvor schon einmal erwähnt, ermöglicht das erfindungsgemäße Auskleiden der Innenwandung des Führungsrohrs 1 mit Graphitfilz 4 eine stabile Verdampfung von Kohlenstoff mittels einer anodischen Bogenverdampfung.

Nachfolgend werden lediglich beispielhaft einige konkrete Werte angegeben, um zu verdeutlichen, was für harte Kohlenstoffschichten mit einer erfindungsgemäßen Vorrichtung und einem erfindungsgemäßen Verfahren abgeschieden werden können.

Bei einer ersten Versuchsanordnung wird ein Graphitstab mit einem Durchmesser von 10 mm als Verdampfungsmaterial 2 innerhalb einer Vakuumkammer verdampft. Der Graphitstab befindet sich in einem Führungsrohr 1 mit einem Innendurchmesser von 25 mm. Die Innenwandung des Führungsrohrs 1 ist derart mit Graphitfilz 4 ausgekleidet, dass der Graphitfilz 4 sowohl vollumfänglich an der Innenwandung des Führungsrohrs 1 als auch vollumfänglich am Graphitstab anliegt. Zunächst wird mittels der dritten Stromversorgungseinrichtung 14 eine Bogenentladung zwischen der als Hohlkathode ausgebildeten Elektronenquelle 10 und der Anode 11 gezündet, wobei die Stromstärke 60 A beträgt. Dabei fließt das Arbeitsgas Argon durch die Hohlkathode. Der Druck in der Vakuumkammer wird auf 1*10⁻³ mbar eingestellt. Nachdem die Stromversorgungseinrichtungen für die Magnetspulen 6 und 12 eingeschaltet sind, wird auch die erste Stromversorgungseinrichtung 9 zugeschaltet und deren Stromstärke innerhalb von 5 Minuten allmählich von 0 A auf 1 10 A erhöht. Danach wird die Stromstärke der dritten Stromversorgungseinrichtung 14 auf 10 A reduziert und auch der Gasfluss durch die Hohlkathode wird derart reduziert, dass der Druck in der Vakuumkammer 7*10⁻⁴ mbar beträgt. Die Nachführeinrichtung 3 wird in Betrieb genommen, so dass das als Graphitstab ausgebildete Verdampfungsmaterial 2 mit einer Geschwindigkeit von 5 cm/h nach oben geschoben wird. Ein erstes Substrat aus Stahl wird dem Kohlenstoffdampf 6 Minuten lang ausgesetzt. In dieser Zeit scheidet sich eine 1 µm dicke Kohlenstoffschicht auf dem ersten Substrat ab. Durch Messungen mit dem Nanoindentationsverfahren kann gezeigt werden, dass die Schicht eine sehr hohe Härte von 55 GPa und ein Elastizitätsmodul von 490 GPa aufweist.

Bei einer zweiten Versuchsanordnung wird ein Graphitstab mit einem Durchmesser von 12 mm als Verdampfungsmaterial 2 innerhalb einer Vakuumkammer verdampft. Der Graphitstab befindet sich in einem Führungsrohr 1 mit einem Innendurchmesser von 40 mm. Die Innenwandung des Führungsrohrs 1 ist derart mit Graphitfilz 4 ausgekleidet, dass der Graphitfilz 4 sowohl vollumfänglich an der Innenwandung des Führungsrohrs 1 als auch vollumfänglich am Graphitstab anliegt. Zunächst wird mittels der dritten Stromversorgungseinrichtung 14 eine Bogenentladung zwischen der als Hohlkathode ausgebildeten Elektronenquelle 10 und der Anode 11 gezündet, wobei die Stromstärke 60 A beträgt. Dabei fließt das Arbeitsgas Argon durch die Hohlkathode. Der Druck in der Vakuumkammer wird auf 1*10⁻³ mbar eingestellt. Nachdem die Stromversorgungseinrichtungen für die Magnetspulen 6 und 12 eingeschaltet sind, wird auch die erste Stromversorgungseinrichtung 9 zugeschaltet und deren Stromstärke innerhalb von 5 Minuten allmählich von 0 A auf 200 A erhöht. Danach wird die Stromstärke der dritten Stromversorgungseinrichtung 14 auf 10 A reduziert und auch der Gasfluss durch die Hohlkathode wird derart reduziert, dass der Druck in der Vakuumkammer 7*10⁻⁴ mbar beträgt. Die Nachführeinrichtung 3 wird in Betrieb genommen, so dass das als Graphitstab ausgebildete Verdampfungsmaterial 2 mit einer Geschwindigkeit von 15 cm/h nach oben geschoben wird. Ein zweites Substrat aus Stahl wird dem Kohlenstoffdampf 1,5 Minuten lang ausgesetzt. In dieser Zeit scheidet sich eine 1,2 µm dicke Kohlenstoffschicht auf dem zweiten Substrat ab. Durch Messungen mit dem Nanoindentationsverfahren kann gezeigt werden, dass die Schicht eine sehr hohe Härte von 74 GPa und ein Elastizitätsmodul von 680 GPa aufweist.

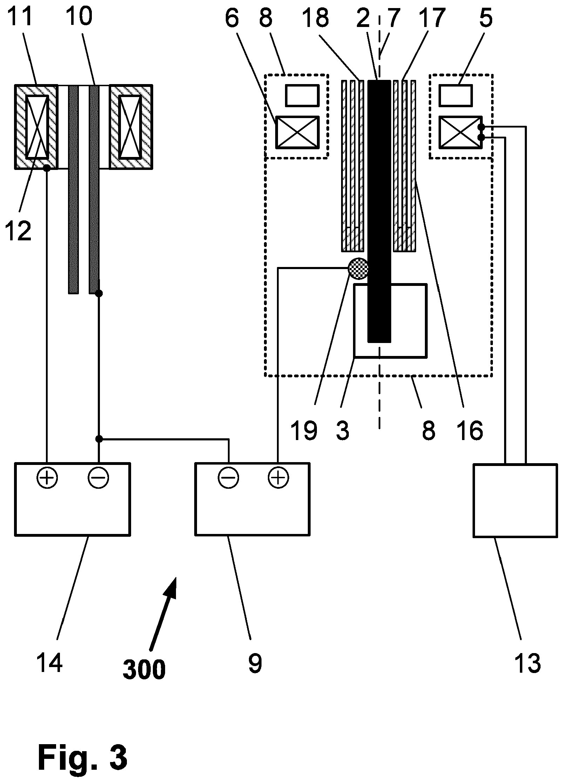

In Fig. 3 ist eine alternative erfindungsgemäße Vorrichtung 300 schematisch dargestellt. Die in Fig. 3 dargestellte Vorrichtung 300 weist in großen Teilen den selben Aufbau auf, wie die erfindungsgemäße Vorrichtung 100 aus Fig. 1. Bauelemente aus Fig. 3 mit identischen Bezugszeichen wie Bauelemente aus Fig 1, weisen daher auch einen gleichen Aufbau und gleiche Funktionsweisen auf.

Die Vorrichtung 300 aus Fig. 3 unterscheidet sich von der Vorrichtung 100 aus Fig. 1 dahingehend, dass das als Graphitstab ausgebildete Verdampfungsmaterial 2 nicht von Graphitfilz sondern zumindest an dem zu verdampfenden Ende des Graphitstabes von drei, voneinander beabstandeten, rohrförmigen Wärmereflektoren 16, 17 und 18 umschlossen ist, welche als Wärmedämmelemente fungieren. Die rohrförmigen Wärmereflektoren 16, 17 und 18 sorgen dafür, dass die Wärme am zu verdampfenden Ende des Graphitstabes erhalten bleibt und der Graphitstab stabil verdampft werden kann.

Ein weiterer Unterschied ist in der Art und Weise der elektrischen Kontaktierung des als Graphitstab ausgebildeten Verdampfungsmaterials 2 gegeben. Bei der Vorrichtung 300 wird der Graphitstab mittels eines Kontaktelements 19 kontaktiert und auf diese Weise eine elektrisch leitfähige Verbindung zum Pluspol der Stromversorgungseinrichtung 9 hergestellt. Das Kontaktelement kann beispielsweise als Schleifkontakt ausgebildet sein.

## Patentansprüche

1. Vorrichtung zum Abscheiden einer Kohlenstoffschicht, umfassend eine erste Stromversorgungseinrichtung (9) zum Ausbilden einer Bogenentladung zwischen einer Elektronenquelle (10) und einem Verdampfungsmaterial (2), wobei der Minuspol der ersten Stromversorgungseinrichtung elektrisch leitfähig mit der Elektronenquelle (10) und der Pluspol der ersten Stromversorgungseinrichtung (9) elektrisch leitfähig mit dem Verdampfungsmaterial (2) verbunden ist; das Verdampfungsmaterial (2) als Graphitstab ausgebildet und zumindest an dem zu verdampfenden Stabende des Graphitstabes von mindestens einem Wärmedämmelement (4; 16; 17; 18) umschlossen ist, **dadurch gekennzeichnet, dass** ein Permanentmagnetsystem (5) und mindestens eine Magnetspule (6) rotationssymmetrisch um das Verdampfungsmaterial (2) angeordnet sind.

2. Vorrichtung nach Anspruch 1, **dadurch gekennzeichnet, dass** das als Graphitstab ausgebildete Verdampfungsmaterial (2) innerhalb eines Führungsrohrs (1) angeordnet und die Innenwandung des Führungsrohrs zumindest an dem zu verdampfenden Stabende des Graphitstabes mit einem porösen Material mit einem Schmelzpunkt größer 2000 °C ausgekleidet ist.

3. Vorrichtung nach Anspruch 2, **dadurch gekennzeichnet, dass** das Führungsrohr (1) einen oberen Anschlag (15) aufweist.

4. Vorrichtung nach Anspruch 2 oder 3, **dadurch gekennzeichnet, dass** das poröse Material Graphitfilz (4) umfasst.

5. Vorrichtung nach Anspruch 1, **dadurch gekennzeichnet, dass** das als Graphitstab ausgebildete Verdampfungsmaterial (2) zumindest an dem zu verdampfenden Ende des Graphitstabes von mindestens zwei, voneinander beabstandeten, rohrförmigen Wärmereflektoren (16; 17; 18) umschlossen ist.

6. Vorrichtung nach Anspruch 1 oder 2, **dadurch gekennzeichnet, dass** die Elektronenquelle (10) als Hohlkathode ausgebildet ist.

7. Vorrichtung nach einem der vorhergehenden Ansprüche, **gekennzeichnet durch** eine zweite Stromversorgungseinrichtung (13), welche elektrisch leitfähig mit der Magnetspule (6) verbunden ist, wobei die zweite Stromversorgungseinrichtung (13) als Puls-Stromversorgungseinrichtung ausgebildet ist.

8. Verfahren zum Abscheiden einer Kohlenstoffschicht, wobei mittels einer ersten Stromversorgungseinrichtung (9) eine Bogenentladung zwischen einer Elektronenquelle (10) und einem Verdampfungsmaterial (2) ausgebildet wird, wobei der Minuspol der ersten Stromversorgungseinrichtung elektrisch leitfähig mit der Elektronenquelle (10) und der Pluspol der ersten Stromversorgungseinrichtung (9) elektrisch leitfähig mit dem Verdampfunqsmaterial (2) verbunden wird, wobei das Verdampfungsmaterial (2) als Graphitstab ausgebildet und zumindest an dem zu verdampfenden Stabende des Graphitstabes von mindestens einem Wärmedämmelement (4; 16; 17; 18) umschlossen wird, **dadurch gekennzeichnet, dass** ein Permanentmagnetsystem (5) und eine Magnetspule (6) rotationssymmetrisch um das Verdampfungsmaterial (2) angeordnet werden.

9. Verfahren nach Anspruch 8, **dadurch gekennzeichnet, dass** die Elektronenquelle (10) als Hohlkathode ausgebildet wird.

10. Verfahren nach Anspruch 8 oder 9, **dadurch gekennzeichnet, dass** eine zweite Stromversorgungseinrichtung (13) elektrisch leitfähig mit der Magnetspule (6) verbunden wird, wobei die zweite Stromversorgungseinrichtung (13) als Puls-Stromversorgungseinrichtung ausgebildet wird.

## Claims

1. Apparatus for depositing a carbon layer, comprising a first power supply device (9) for forming an arc discharge between an electron source (10) and an evaporation material (2), wherein the negative pole of the first power supply device is electrically conductively connected to the electron source (10) and the positive pole of the first power supply device (9) is electrically conductively connected to the evaporation material (2); the evaporation material (2) is embodied as a graphite rod and is surrounded by at least one heat-insulating element (4; 16; 17; 18) at least at the rod end of the graphite rod to be evaporated, **characterized in that** a permanent magnet system (5) and at least one solenoid coil (6) are arranged rotationally symmetrically around the evaporation material (2).

2. Apparatus according to Claim 1, **characterized in that** the evaporation material (2) embodied as a graphite rod is arranged inside a guide tube (1) and the inner wall of the guide tube is lined, at least at the rod end of the graphite rod to be evaporated, with a porous material having a melting point greater than 2000°C.

3. Apparatus according to Claim 2, **characterized in that** the guide tube (1) has an upper stop (15).

4. Apparatus according to Claim 2 or 3, **characterized in that** the porous material comprises graphite felt (4).

5. Apparatus according to Claim 1, **characterized in that** the evaporation material (2) embodied as a graphite rod is surrounded, at least at the end of the graphite rod to be evaporated, by at least two mutually spaced-apart tubular heat reflectors (16; 17; 18).

6. Apparatus according to Claim 1 or 2, **characterized in that** the electron source (10) is embodied as a hollow cathode.

7. Apparatus according to any of the preceding claims, **characterized by** a second power supply device (13), which is electrically conductively connected to the solenoid coil (6), the second power supply device (13) being embodied as a pulsed power supply device.

8. Method for depositing a carbon layer, wherein an arc discharge is formed between an electron source (10) and an evaporation material (2) by means of a first power supply device (9), wherein the negative pole of the first power supply device is electrically conductively connected to the electron source (10) and the positive pole of the first power supply device (9) is electrically conductively connected to the evaporation material (2), wherein the evaporation material (2) is embodied as a graphite rod and is surrounded by at least one heat-insulating element (4; 16; 17; 18) at least at the rod end of the graphite rod to be evaporated, **characterized in that** a permanent magnet system (5) and a solenoid coil (6) are arranged rotationally symmetrically around the evaporation material (2).

9. Method according to Claim 8, **characterized in that** the electron source (10) is embodied as a hollow cathode.

10. Method according to Claim 8 or 9, **characterized in that** a second power supply device (13) is electrically conductively connected to the solenoid coil (6), the second power supply device (13) being embodied as a pulsed power supply device.

## Revendications

1. Dispositif permettant de déposer une couche de carbone, comprenant un premier dispositif d'alimentation électrique (9) pour réaliser une décharge en arc entre une source d'électrons (10) et un matériau d'évaporation (2), dans lequel le pôle négatif du premier dispositif d'alimentation électrique est relié de manière électriquement conductrice à la source d'électrons (10) et le pôle positif du premier dispositif d'alimentation électrique (9) est relié de manière électriquement conductrice au matériau d'évaporation (2) ; le matériau d'évaporation (2) est réalisé sous forme de barre de graphite et est entouré au moins à l'extrémité de barre à évaporer de la barre de graphite par au moins un élément d'isolation thermique (4 ; 16 ; 17 ; 18),
**caractérisé en ce qu'**un système d'aimant permanent (5) et au moins une bobine magnétique (6) sont disposés en symétrie de révolution autour du matériau d'évaporation (2).

2. Dispositif selon la revendication 1, **caractérisé en ce que** le matériau d'évaporation (2) réalisé sous forme de barre de graphite est disposé à l'intérieur d'un tube de guidage (1) et la paroi intérieure du tube de guidage est habillée au moins à l'extrémité de barre à évaporer de la barre de graphite d'un matériau poreux ayant un point de fusion supérieur à 2000 °C.

3. Dispositif selon la revendication 2, **caractérisé en ce que** le tube de guidage (1) présente une butée supérieure (15).

4. Dispositif selon la revendication 2 ou 3, **caractérisé en ce que** le matériau poreux comprend du feutre en graphite (4).

5. Dispositif selon la revendication 1, **caractérisé en ce que** le matériau d'évaporation (2) réalisé sous forme de barre de graphite est entouré au moins à l'extrémité à évaporer de la barre de graphite par au moins deux réflecteurs de chaleur tubulaires (16 ; 17 ; 18) espacés les uns des autres.

6. Dispositif selon la revendication 1 ou 2, **caractérisé en ce que** la source d'électrons (10) est réalisée sous forme de cathode creuse.

7. Dispositif selon l'une quelconque des revendications précédentes, **caractérisé par** un deuxième dispositif d'alimentation électrique (13) qui est relié de manière électriquement conductrice à la bobine magnétique (6), dans lequel le deuxième dispositif d'alimentation électrique (13) est réalisé sous forme de dispositif d'alimentation électrique à impulsion.

8. Procédé permettant de déposer une couche de carbone, dans lequel, au moyen d'un premier dispositif d'alimentation électrique (9), une décharge en arc est réalisée entre une source d'électrons (10) et un matériau d'évaporation (2),
dans lequel le pôle négatif du premier dispositif d'alimentation électrique est relié de manière électriquement conductrice à la source d'électrons (10) et le pôle positif du premier dispositif d'alimentation électrique (9) est relié de manière électriquement conductrice au matériau d'évaporation (2) ; dans lequel le matériau d'évaporation (2) est réalisé sous forme de barre de graphite et est entouré au moins à l'extrémité de barre à évaporer de la barre de graphite par au moins un élément d'isolation thermique (4 ; 16 ; 17 ; 18),
**caractérisé en ce qu'**un système d'aimant permanent (5) et une bobine magnétique (6) sont disposés en symétrie de révolution autour du matériau d'évaporation (2) .

9. Procédé selon la revendication 8, **caractérisé en ce que** la source d'électrons (10) est réalisée sous forme de cathode creuse.

10. Procédé selon la revendication 8 ou 9, **caractérisé en ce qu'**un deuxième dispositif d'alimentation électrique (13) est relié de manière électriquement conductrice à la bobine magnétique (6), dans lequel le deuxième dispositif d'alimentation électrique (13) est réalisé sous forme de dispositif d'alimentation électrique à impulsion.
